(19) Europäisches Patentamt
European Patent Office
Office européen des brevets

(11) **EP 2 811 307 B1**

(12) **EUROPEAN PATENT SPECIFICATION**

(45) Date of publication and mention
of the grant of the patent:
**15.02.2017 Bulletin 2017/07**

(51) Int Cl.:
***G01R 29/08*** (2006.01)

(21) Application number: **14169931.4**

(22) Date of filing: **27.05.2014**

(54) **System for vector measurement of the electromagnetic field intensity**

System zur Vektormessung der Intensität des elektromagnetischen Feldes

Système pour la mesure vectorielle de l´intensité du champ électromagnétique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.05.2013 CZ 20130396**

(43) Date of publication of application:
**10.12.2014 Bulletin 2014/50**

(73) Proprietor: **Czech Technical University in Prague -
Faculty of Electrical Engineering
166 27 Praha 6 (CZ)**

(72) Inventor: **Hoffmann, Karel
162 00 Praha 6 (CZ)**

(74) Representative: **Duskova, Hana
Czech Technical University in Prague
Patent Centre
Zikova 4
166 36 Praha 6 (CZ)**

(56) References cited:
**GB-A- 2 339 917          JP-A- 2006 074 350
US-A1- 2002 093 342     US-A1- 2004 196 083**

• **YAROVOY A G ET AL: "UWB Radars for
Chalenging Applications", ULTRAWIDEBAND
AND ULTRASHORT IMPULSE SIGNALS, THE
THIRD INTERNATIONAL CONFERENCE, IEEE, PI,
1 September 2006 (2006-09-01), pages 50-55,
XP031046647, DOI: 10.1109/UWBUS.2006.307157
ISBN: 978-1-4244-0513-8**
• **ZELA J.; HOFFMANN K.; HUDEC P.: "Errors in
Measurement of Microwave Interferograms
Using Antenna Matrix", RADIOENGINEERING,
vol. 17, no. 2, September 2008 (2008-09), pages
25-32, XP008172804,**

**Description**

Background of the Invention

Presented solution deals with the connection of a measuring system for vector measurement of the electromagnetic field intensity distribution in free space.

Description of Prior Art

For active displaying systems operating with microwaves or even sub-millimeter waves it is necessary, especially for safety applications, to obtain real-time vector data about distribution of intensity of the electromagnetic field on suitable area or in suitable space, which carries information about the examined person or object (examined object). Image of the examined object can then be obtained from the vector information about the electromagnetic field intensity distribution by means of holographic techniques or by synthetic aperture techniques without the need to use lenses or reflectors for focusing. All focusing is done mathematically by the computer image reconstruction technique.

Electromagnetic field intensity distribution in space can be measured in vectors by a sensor connected to the vector network analyzer (VNA) while its position changes in the given space. The VNA records the values of magnitude and phase of the electromagnetic field intensity in individual points. This solution requires to place the sensor on mechanical positioning system. Inevitably, such measurement is slow and therefore it is not usable e.g. for displaying systems operating in real time.

For active displaying systems operating in real time were for this reason developed one-dimensional antenna arrays on the systems' receiving part that mechanically scan the second dimension, or directly two-dimensional antenna arrays, as described in D. M. Sheen, D. L. McMakin, T. E. Hall "Three-Dimensional Millimeter-Wave Imaging for Concealed Weapon Detection," IEEE Trans. Microwave Theory Tech., vol. 49, pp. 1581-1592, September 2001, and in F. Friederich, W. Spiegel, M. Bauer, F. Meng, M. D. Thompson, S. Boppel, A. Lisauskas, B. Hils, G. Spickermann, P. H. Bolívar, H. G. Roskos, "THz Active Imaging Systems with Real-Time Capabilities," IEEE Trans. Terahertz Science and Technology, vol. 1, No. 1, pp. 183-200, September 2011.

Each element of these antenna arrays has a mixer connected behind the receiving antenna and to this mixer is brought a signal from local oscillator. Antenna array therefore requires that the signal from local oscillator is brought to each element of the antenna. Receiving part of the displaying system thus must contain relevant number of power splitters, most commonly binary ones, which split the signal from the local oscillator successively down to the individual antennas mixers. The mixers produce an intermediate frequency signal carrying the information about the magnitude and phase of the electromagnetic field intensity in the place where the antenna is located for subsequent processing. Setback of this design solution is the need to use multiple power splitters based on the number of the antenna array elements, which introduces undesirable losses during the power splitting. Such losses may possibly be compensated by an amplifier before each mixer. The system is complex and therefore also costly. Especially in the sphere of sub-millimeter waves the price is a significant aspect. Receiving antenna matrix thus often contains only a limited number of elements and the required resolution is achieved by complementing the system with mechanically wobbled mirrors.

There is also another option to process the signal from individual antennas in the antenna array. The signals from individual antennas are successively connected to the VNA input by the electronically switched microwave switchers, as described in the publication Zela J., Hoffmann K., Hudec P., "Errors in Measurement of Microwave Interferograms Using Antenna Matrix", Radioengineering, vol. 17, No. 2, September 2008, pp. 25-32. The system however requires laborious calibration and is usable only at lower microwave frequencies, for which the needed switchers are available. Common disadvantage of both design solutions mentioned above is their complexity and expensiveness.

Summary of the Invention

Disadvantages mentioned above are removed by the system for vector measurement of the electromagnetic field intensity according to the presented solution, as defined in claims 1 and 4. Such a system comprises a transmitting antenna, microwave generator and the antenna array of receiving antennas where the outputs of the individual antennas in the receiving antenna array are via the power sensors connected directly or through the block of switches to the A/D converter connected to the computer controlling the block of switches. The principle of the new solution is creation of two channels with two transmitting antennas. One channel is a testing channel with the transmitting antenna of the testing channel connected to the microwave output of the microwave generator via the first output of the power splitter. The second channel is a reference channel with the transmitting antenna of the reference channel. The transmitting antenna of the reference channel is connected to the microwave output of the microwave generator via the second output of the power splitter. The block controlling the phase and/or magnitude is connected between the first output of the power splitter and the transmitting antenna of the testing channel and/or between the second output of the power splitter and the transmitting antenna of the reference channel. Transmitting antenna of the testing channel, transmitting antenna of the reference channel and the receiving antenna array are placed in space in one of the following arrangements. In one arrangement the radiation pattern of the transmitting antenna of the testing channel and the radiation pattern of the transmitting antenna of the reference channel are oriented in direction to the receiving antenna array and simultaneously the radiation pattern of the receiving antenna array is oriented in direction to the transmitting antenna of the testing channel and to the transmitting antenna of the reference channel. In the second arrangement the radiation pattern of the transmitting antenna of the testing channel is oriented in direction to the examined object and the radiation pattern of the transmitting antenna of the reference channel is oriented in direction to the receiving antenna array and the radiation pattern of the receiving antenna array is oriented in direction to the examined object and to the transmitting antenna of the reference channel.

In an advantageous embodiment the block controlling the phase and/or magnitude is interconnected with the computer. Advantageously, the microwave generator is tunable.

The second possible embodiment of the same system is that it again consists of the testing channel with the transmitting antenna of the testing channel and the reference channel with the transmitting antenna of the reference channel. Transmitting antenna of the testing channel is connected to the microwave output of the first microwave generator and the transmitting antenna of the reference channel is connected to the microwave output of the second microwave generator, while its signal is coherent with the signal of the first microwave generator. The first and second microwave generators are interconnected with the block controlling mutual phase shift and the magnitude of the coherent signals with the option to set the mutual phase shift and magnitude of these coherent signals by the computer. Again, this embodiment allows two arrangements of the transmitting and receiving antennas. In the first arrangement the transmitting antenna of the testing channel, the transmitting antenna of the reference channel and the receiving antenna array are placed in space in such a way that the radiation pattern of the transmitting antenna of the testing channel and radiation pattern of the transmitting antenna of the reference channel are oriented in direction to the receiving antenna array and simultaneously the radiation pattern of the receiving antenna array is oriented in direction to the transmitting antenna of the testing channel and the transmitting antenna of the reference channel. In the second arrangement the radiation pattern of the transmitting antenna of the testing channel is oriented in direction to the examined object and the transmitting antenna of the reference channel is oriented in direction to the receiving antenna array and simultaneously the radiation pattern of the receiving antenna array is oriented in direction to the examined object and the transmitting antenna of the reference channel. Advantageously, the first and the second microwave generator are tunable.

The advantage of this connection is that it allows for vector measurement of the electromagnetic field intensity without the need to distribute the microwave signal of the local oscillator to the mixers of individual antennas of the receiving antenna array through microwave network structure consisting of many power splitters as it is necessary for the existing measuring systems. Therefore, the receiving antenna array can be realized in an easier and less expensive way.

Explanation of Drawings

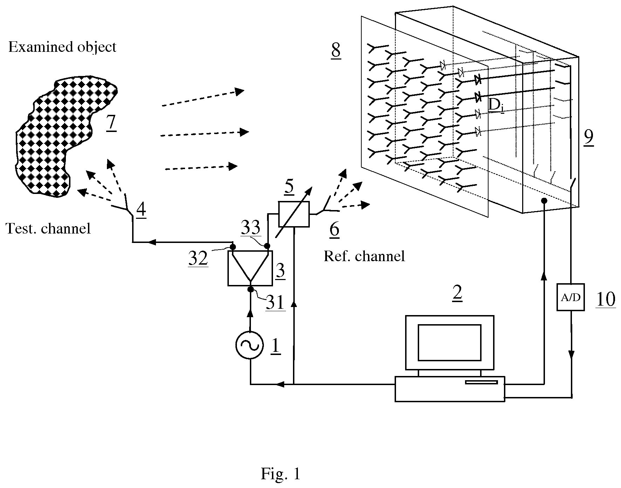

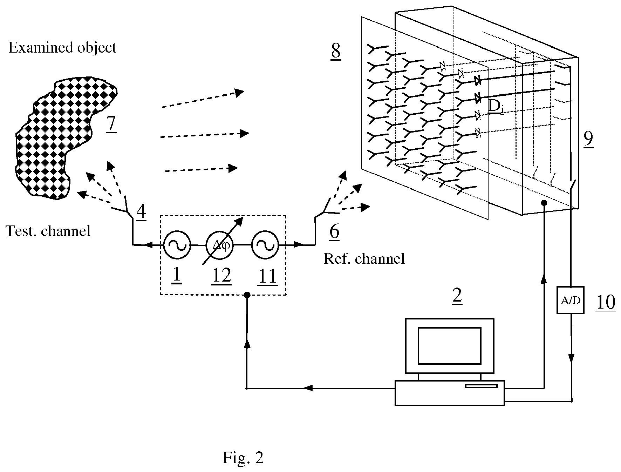

Fig. 1 shows the block diagram of one of possible embodiments of the system and Fig. 2 shows the block diagram of the second possible embodiment of the described system.

Detailed Description of the Preferred Embodiments

One possible example of connection of the system for vector measurement of the electromagnetic field intensity is shown in Fig. 1. The connection here is formed by the microwave generator $\underline{1}$, which is advantageously tunable. It may be controlled manually but in practice it will preferably be controlled by the computer $\underline{2}$. The microwave output of the microwave generator $\underline{1}$ is connected to the input $\underline{31}$ of the power splitter $\underline{3}$. The first output $\underline{32}$ of the power splitter $\underline{3}$ is connected to the transmitting antenna $\underline{4}$ of the testing channel. The second output $\underline{33}$ of the power splitter $\underline{3}$ is via the block $\underline{5}$ controlling the phase and/or magnitude, advantageously controlled by the computer $\underline{2}$, connected to the transmitting antenna $\underline{6}$ of the reference channel. The electromagnetic field radiated by the transmitting antenna $\underline{4}$ of the testing channel is reflected from the examined object $\underline{7}$, in other possible arrangement in space it passes through or is dispersed by the examined object $\underline{7}$, and it comes to the individual receiving antennas of the antenna array $\underline{8}$ of the receiving antennas. It means that the radiation pattern of the transmitting antenna $\underline{4}$ of the testing channel is oriented in direction to the examined object $\underline{7}$ and the radiation pattern of the receiving antenna array $\underline{8}$ is oriented also in direction to the examined object $\underline{7}$. At the output of the $i$-th receiving antenna of the antenna array $\underline{8}$ of the receiving antennas is generated the signal $a_i=|a_i|e^{j(\varphi_{ai})}$, $i=1...n$, where n is the number of the receiving antennas of the antenna array $\underline{8}$ of the receiving antennas. Simultaneously, each $i$-th receiving antenna of the antenna array $\underline{8}$ receives coherent electromagnetic field radiated by the transmitting antenna $\underline{6}$ of the reference channel, which at its output generates the signal $b_i = |b_i|e^{j(\varphi_{bi})}$ It means that the radiation pattern of the transmitting antenna $\underline{6}$ of the reference channel is oriented in direction to the

receiving antenna array $\underline{8}$ and the radiation pattern of the receiving antenna array $\underline{8}$ is oriented in direction to the transmitting antenna $\underline{6}$ of the reference channel. The output of each receiving antenna is connected to the power sensor $\underline{D}_i$, for example to the detector, and the measured received power is defined by the formula:

$$P_i = \left| a_i + b_i \right|^2$$

(1)

Relevant DC voltage at the output of each detector $\underline{D}_i$ is then successively brought via the block $\underline{9}$ of switchers controlled by the computer $\underline{2}$ to the A/D converter $\underline{10}$ connected to the computer $\underline{2}$.

Measured power $P_i$ depends on the magnitudes of signals $|a_i|$ and $|b_i|$ and on their mutual phase defined as:

$$\Delta \varphi_i = \varphi_{ai} - \varphi_{bi}$$

(2)

Phase of the reference signal $\varphi_{bi}$ and/or magnitude $|b_i|$ can be changed in a defined way by means of the block $\underline{5}$ controlling the phase and/or magnitude. Its every single setting corresponds to one equation (1). Minimum four different equations (1) are needed to distinctively determine the signal $a_i = |a_i| e^{j(\varphi_{ai})}$, and therefore also the magnitude and phase of the measured electromagnetic field intensity in the place where the receiving antenna is located by methodology compliant with Engen, G. F., "The Six-Port Reflectometer: An Alternative Network Analyzer," IEEE Trans. Microwave Theory Tech., vol. 25, pp. 1075-1080, December 1997 or Oldfield, L. C., Ide, J. P., and Griffin, E. J. "A Multistate reflectometer", IEEE Trans. IM., vol. 34, No. 2, pp. 198-201, June 1985, by means of the computer $\underline{2}$. Higher number of measurements for different settings of the block $\underline{5}$ controlling the phase and/or magnitude advantageously results in more robust measurement. More robust measurement is also achieved by measuring at multiple frequencies of the microwave generator $\underline{1}$.

Another possible design solution has the block $\underline{5}$ controlling the phase and/or magnitude connected between the first output $\underline{32}$ of the power splitter $\underline{3}$ and the transmitting antenna $\underline{4}$ of the testing channel. It is also possible to use two blocks $\underline{5}$ controlling the phase and/or magnitude connected between the output $\underline{32}$ of the power splitter $\underline{3}$ and the transmitting antenna $\underline{4}$ of the testing channel and between the second output $\underline{33}$ of the power splitter $\underline{3}$ and the transmitting antenna $\underline{6}$ of the reference channel.

In another possible design solution the transmitting antenna 6 of the reference channel directly radiates to the receiving antenna array $\underline{8}$, which means that the radiation pattern of the transmitting antenna $\underline{6}$ of the reference channel is oriented in direction to the receiving antenna array $\underline{8}$ and the radiation pattern of the receiving antenna array $\underline{8}$ is oriented in direction to the transmitting antenna $\underline{6}$ of the reference channel. Transmitting antenna $\underline{4}$ of the testing channel also directly radiates to the receiving antenna array $\underline{8}$, which means that the radiation pattern of the transmitting antenna $\underline{4}$ of the testing channel is oriented in direction to the receiving antenna array $\underline{8}$ and the radiation pattern of the receiving antenna array $\underline{8}$ is oriented in direction to the transmitting antenna $\underline{4}$ of the testing channel. This arrangement can be used e.g. for measuring the characteristics of unknown antenna connected instead of the transmitting antenna $\underline{4}$ of the testing channel.

Instead of one microwave generator $\underline{1}$ another possible design solution uses a system consisting of two microwave generators $\underline{1}$ and $\underline{11}$ with coherent signals at their outputs with the option to set the mutual phase shift $\Delta\varphi$ and the magnitude of these signals, see Fig. 2. This is made possible because between the first microwave generator $\underline{1}$ and the second microwave generator $\underline{11}$ is inserted the block $\underline{12}$ controlling the mutual phase shift and magnitude of coherent signals with the option to control the mutual phase shift and magnitude of these coherent signals by the computer $\underline{2}$. Both microwave generators $\underline{1}$ and $\underline{11}$ may advantageously be tunable. The first microwave generator $\underline{1}$ is then directly connected to the transmitting antenna $\underline{4}$ of the testing channel and the second microwave generator $\underline{11}$ is directly connected to the transmitting antenna $\underline{6}$ of the reference channel. Power splitter $\underline{3}$ and the block $\underline{5}$ controlling the phase and/or magnitude are not used in this case because their functions are overtaken directly by the both microwave generators $\underline{1}$ and $\underline{11}$.

Electromagnetic field radiated by the transmitting antenna $\underline{4}$ of the testing channel reflects from the examined object $\underline{7}$, in other possible arrangement in space it passes through or is dispersed by the examined object $\underline{7}$, and it comes to the individual receiving antennas of the antenna array $\underline{8}$ of the receiving antennas. It means that the radiation pattern of the transmitting antenna $\underline{4}$ of the testing channel is oriented in direction to the examined object $\underline{7}$ and the radiation pattern of the receiving antenna array $\underline{8}$ is oriented also in direction to the examined object $\underline{7}$. At the output of the $i$-th antenna is generated the signal $a_i = |a_i| e^{j(\varphi_{ai})}$, $i=1,...,n$, where n is the number of the receiving antennas of the antenna array 8. Simultaneously, each *i*-th receiving antenna of the antenna array 8 receives coherent electromagnetic field radiated by the transmitting antenna 6 of the reference channel, which at its output generates the signal $b_i = |b_i|e^{j(\varphi_{bi})}$, It means that the radiation pattern of the transmitting antenna 6 of the reference channel is oriented in direction to the receiving antenna array 8 and the radiation pattern of the receiving antenna array 8 is oriented in direction to the transmitting antenna 6 of the reference channel. The output of each receiving antenna is connected to the power sensor $D_i$, for example to the detector, and the measured received power is defined by the formula:

$$P_i = |a_i + b_i|^2$$

(3)

Relevant DC voltage at the output of each detector $D_i$ is then successively brought via the block 9 of switchers controlled by the computer 2 to the A/D converter 10 connected to the computer 2.

Measured power $P_i$ depends on the magnitudes of signals $|a_i|$ and $|b_i|$ and on their mutual phase shift defined as:

$$\Delta\varphi_i = \varphi_{ai} - \varphi_{bi}$$

(4)

Phase of the reference signal $\varphi_{bi}$ and/or magnitude $|b_i|$ can be changed in a defined way by setting the phase shift $\Delta\varphi$ between the coherent signals of the first microwave generator 1 and the second microwave generator 11 by changing the signal phase and/or magnitude of the second microwave generator 11. Its every single setting corresponds to one equation (3). Minimum four different equations (3) are needed to distinctively determine the signal $a_i = |a_i|e^{j(\varphi_{ai})}$, and therefore also the magnitude and phase of the measured electromagnetic field intensity in the place where the receiving antenna is located by the same methodology as in the previous case, all controlled by the computer 2. Higher number of measurements for different settings of the block 12 controlling the phase and/or magnitude advantageously results in more robust measurement. More robust measurement is also achieved by measuring at multiple frequencies of the microwave generators 1 and 11.

In another possible arrangement the functions of the microwave generators 1 and 11 are swapped.

It is also possible to create an arrangement where the signal phase and/or magnitude change at both microwave generators 1 and 11.

Properties of the measuring system were experimentally tested within the frequency range 8-12 GHz. Phase $\varphi_{ai}$ was measured with deviation of units of degrees maximum as compared with the measurements made by the vector network analyzer Agilent E8364A.

Industrial Applicability

System for vector measurement of the electromagnetic field intensity can be industrially applied anywhere where it is necessary to perform vector measurements of the electromagnetic field distribution in space. These may include e.g. a displaying system in the range of microwaves or sub-mm waves. Another possible application is e.g. vector measurements of antennas radiation patterns.

**Claims**

1.  System for vector measurement of the electromagnetic field intensity, said system comprising a transmitting antenna (4) of a testing channel, a microwave generator (1), an antenna array (8) of receiving antennas having outputs of individual antennas, power sensors ($D_i$), a block (9) of switches, an A/D converter (10), a computer (2), a power splitter (3) having a first output (32) and a second output (33) and a transmitting antenna (6) of a reference channel, where the outputs of individual antennas of the antenna array (8) are via said power sensors ($D_i$) connected directly or through the block (9) of switches to the A/D converter (10) interconnected with the computer (2) controlling the block (9) of switches, a testing channel being formed by the transmitting antenna (4) of the testing channel connected to the microwave output of the microwave generator (1) via the first output (32) of the power splitter (3) and a reference channel being formed by the transmitting antenna (6) of the reference channel, which is connected to the microwave output of the microwave generator (1) via the second output (33) of the power splitter (3), **characterised in that** between the first output (32) of the power splitter (3) and the transmitting antenna (4) of the testing channel and/or between the second output (33) of the power splitter (3) and the transmitting antenna (6) of the reference channel is connected a block (5) controlling the phase and/or magnitude, while the transmitting antenna (4) of the testing channel, transmitting antenna (6) of the reference channel and the receiving antenna array (8) are placed in space in such a way that the radiation pattern of the transmitting antenna (4) of the testing channel and the radiation pattern of the transmitting antenna (6) of the reference channel are oriented in direction to the receiving antenna array (8) and simultaneously the radiation pattern of the receiving antenna array (8) is oriented in direction to the transmitting antenna (4) of the testing channel and to the transmitting antenna (6) of the reference channel, or the radiation pattern of the transmitting antenna (4) of the testing channel is oriented in direction to the examined object (7) and the radiation pattern of the transmitting antenna (6) of the reference channel is oriented in direction to the receiving antenna array (8) and the radiation pattern of the receiving antenna array (8) is oriented in direction to the examined object (7) and the transmitting antenna (6) of the reference channel.

2. System according to claim 1 **characterized by the fact that** the block (5) controlling the phase and/or magnitude is interconnected with the computer (2).

3. System according to claim 1 or 2 **characterized by the fact that** the microwave generator (1) is tunable.

4. System for vector measurement of the electromagnetic field intensity, said system comprising a transmitting antenna (4) of a testing channel, a first microwave generator (1), an antenna array (8) of receiving antennas having outputs of individual antennas, power sensors (Di), a block (9) of switches, an A/D converter (10), a computer (2) and a transmitting antenna (6) of a reference channel, where the outputs of individual antennas of the receiving antenna array (8) are via power sensors ($D_i$) connected directly or through the block (9) of switches to the A/D converter (10) interconnected with the computer (2) controlling the block (9) of switches, a testing channel being formed by the transmitting antenna (4) of the testing channel connected to the microwave output of the first microwave generator (1) and a reference channel being formed by the transmitting antenna (6) of the reference channel, **characterised in that** said system further comprises a second microwave generator (11), the transmitting antenna (6) of the reference channel being connected to a microwave output of the second microwave generator (11), the signal of the second microwave generator (11) being coherent with the signal of the first microwave generator (1), where the first microwave generator (1) and the second microwave generator (11) are interconnected with a block (12) controlling the mutual phase shift and magnitude of their coherent signals with the option to set the mutual phase shift and magnitude of these coherent signals by the computer (2), while the transmitting antenna (4) of the testing channel, transmitting antenna (6) of the reference channel and the receiving antenna array (8) are placed in space in such a way that the radiation pattern of the transmitting antenna (4) of the testing channel and the radiation pattern of the transmitting antenna (6) of the reference channel are oriented in direction to the receiving antenna array (8) and simultaneously the radiation pattern of the receiving antenna array (8) is oriented in direction to the transmitting antenna (4) of the testing channel and the transmitting antenna (6) of the reference channel, or the radiation pattern of the transmitting antenna (4) of the testing channel is oriented in direction to the examined object (7) and the radiation pattern of the transmitting antenna (6) of the reference channel is oriented in direction to the receiving antenna array (8) and the radiation pattern of the receiving antenna array (8) is oriented in direction to the examined object (7) and the transmitting antenna (6) of the reference channel.

5. System according to claim 4 **characterized by the fact that** the first microwave generator (1) and the second microwave generator (11) are tunable.

**Patentansprüche**

1. System zur Vektormessung der Intensität vom elektromagnetischen Feld, in dem dieses System eine Sendeantenne (4) des Testkanals, einen Mikrowellengenerator (1), eine Antennenreihe (8) der Empfangsantennen, die mit den Ausgängen von den einzelnen Antennen versehen sind, Leistungssensoren (Di), eine Schalterleiste (9), einen A/D-Wandler (10), einen Rechner (2), einen Leistungsteiler (3), der über den ersten Ausgang (32) und den zweiten Ausgang (33) verfügt, und eine Sendeantenne (6) des Referenzkanals beinhält, wo die Ausgänge von den einzelnen Antennen der jeweiligen Antennenreihe (8) über die Leistungssensoren ($D_i$) unmittelbar oder über die Schalterleiste (9) mit dem A/D-Wandler (10) verbunden sind, der mit dem die Schalterleiste (9) steuernden Rechner (2) durchgeschaltet ist, der Testkanal aus der Sendeantenne (4) des Testkanals besteht, die an den Mikrowellen-Ausgang des Mikrowellengenerators (1) über den ersten Ausgang (32) des Leistungsteilers (3) angeschlossen ist und der Referenzkanal aus der Sendeantenne (6) des Referenzkanals besteht, die an den Mikrowellen-Ausgang des Mikrowellengenerators (1) über den zweiten Ausgang (33) des Leistungsteilers (3) angeschlossen ist, **dadurch gekenn-**

**zeichnet, dass,** zwischen den ersten Ausgang (32) des Leistungsteilers (3) und die Sendeantenne (4) des Testkanals und/oder zwischen den zweiten Ausgang (33) des Leistungsteilers (3) und die Sendeantenne (6) des Referenzkanals ein Block (5) für die Steuerung der Phase und/oder Amplitude geschaltet ist, wobei die Sendeantenne (4) des Testkanals, die Sendeantenne (6) des Referenzkanals und die Empfangsantennenreihe (8) räumlich so angebracht sind, dass die Strahlungskennlinie der Sendeantenne (4) des Testkanals und die Strahlungskennlinie der Sendeantenne (6) des Referenzkanals in Richtung zur Empfangsantennenreihe (8) ausgerichtet sind und gleichzeitig die Strahlungskennlinie der Empfangsantennenreihe (8) in Richtung zur Sendeantenne (4) des Testkanals und zur Sendeantenne (6) des Referenzkanals ausgerichtet ist oder die Strahlungskennlinie der Sendeantenne (4) des Testkanals in Richtung zum zu untersuchenden Objekt (7) ausgerichtet ist und die Strahlungskennlinie der Sendeantenne (6) des Referenzkanals in Richtung zur Empfangsantennenreihe (8) ausgerichtet ist und die Strahlungskennlinie der Empfangsantennenreihe (8) in Richtung zum zu untersuchenden Objekt (7), sowie zur Sendeantenne (6) des Referenzkanals ausgerichtet ist.

2. System nach dem Anspruch 1, **dadurch gekennzeichnet, dass** der Block (5) für die Steuerung der Phase und/oder Amplitude mit dem Rechner (2) durchgeschaltet ist.

3. System nach dem Anspruch 1 oder 2, **dadurch gekennzeichnet, dass** der Mikrowellengenerator (1) umstimmbar ist.

4. System zur Vektormessung der Intensität vom elektromagnetischen Feld, in dem dieses System eine Sendeantenne (4) des Testkanals, den ersten Mikrowellengenerator (1), eine Antennenreihe (8) der Empfangsantennen mit den Ausgängen von den einzelnen Antennen, Leistungssensoren ($D_i$), eine Schalterleiste (9), einen A/D-Wandler (10), einen Rechner (2) und eine Sendeantenne (6) des Referenzkanals beinhält, wo die Ausgänge von den einzelnen Antennen der jeweiligen Antennenreihe (8) der Empfangsantennen über die Leistungssensoren ($D_i$) unmittelbar oder über die Schalterleiste (9) mit dem A/D-Wandler (10) verbunden sind, der mit dem die Schalterleiste (9) steuernden Rechner (2) durchgeschaltet ist, der Testkanal aus der Sendeantenne (4) des Testkanals besteht, die an den Mikrowellen-Ausgang des ersten Mikrowellengenerators (1) angeschlossen ist und der Referenzkanal aus der Sendeantenne (6) des Referenzkanals besteht, **dadurch gekennzeichnet, dass** dieses System weiter den zweiten Mikrowellengenerator (11) beinhält, die Sendeantenne (6) des Referenzkanals an den Mikrowellen-Ausgang des zweiten Mikrowellengenerators (11) angeschlossen ist, dessen Signal mit dem Signal des ersten Mikrowellengenerators (1) kohärent ist, wo der erste Mikrowellengenerator (1) und der zweite Mikrowellengenerator (11) mit dem Block (12) zur Steuerung der gegenseitigen Phasenverschiebung und der Amplitude deren kohärenten Signale durchgeschaltet sind, um die Einstellung der gegenseitigen Phasenverschiebung sowie der Amplitude dieser kohärenten Signale durch den Rechner (2) zu ermöglichen, wobei die Sendeantenne (4) des Testkanals, die Sendeantenne (6) des Referenzkanals und die Empfangsantennenreihe (8) räumlich so angebracht sind, dass die Strahlungskennlinie der Sendeantenne (4) des Testkanals und die Strahlungskennlinie der Sendeantenne (6) des Referenzkanals in Richtung zur Empfangsantennenreihe (8) ausgerichtet sind und gleichzeitig die Strahlungskennlinie der Empfangsantennenreihe (8) in Richtung zur Sendeantenne (4) des Testkanals und zur Sendeantenne (6) des Referenzkanals ausgerichtet ist oder die Strahlungskennlinie der Sendeantenne (4) des Testkanals in Richtung zum zu untersuchenden Objekt (7) ausgerichtet ist und die Strahlungskennlinie der Sendeantenne (6) des Referenzkanals in Richtung zur Empfangsantennenreihe (8) ausgerichtet ist und die Strahlungskennlinie der Empfangsantennenreihe (8) in Richtung zum zu untersuchenden Objekt (7), sowie zur Sendeantenne (6) des Referenzkanals ausgerichtet ist.

5. System nach dem Anspruch 4, **dadurch gekennzeichnet, dass** der erste Mikrowellengenerator (1), sowie der zweite Mikrowellengenerator (11) umstimmbar sind.

## Revendications

1. Système pour la mesure vectorielle de l'intensité du champ électromagnétique, où ce système contient une antenne (4) d'émission d'un canal d'essai, un générateur (1) de micro-ondes, un ensemble (8) d'antennes des antennes de réception ayant les sorties des antennes particulières, des capteurs de puissance ($D_i$), un bloc (9) de commutateurs, un convertisseur A/N (10), un ordinateur (2), un diviseur (3) de puissance ayant la première sortie (32) et la deuxième sortie (33), et une antenne (6) d'émission d'un canal de référence, où les sorties des antennes particulières de l'ensemble (8) d'antennes sont par les capteurs de puissance ($D_i$) connectées directement ou à l'aide du bloc (9) de commutateurs avec le convertisseur A/N (10) interconnecté avec l'ordinateur (2) gérant le bloc (9) de commutateurs, le canal d'essai est fait par l'antenne (4) d'émission du canal d'essai connectée à la sortie de micro-ondes du générateur (1) de micro-ondes par la première sortie (32) du diviseur (3) de puissance et le canal de référence est fait par l'antenne (6) d'émission du canal de référence, qui est connectée à la sortie de micro-ondes du générateur (1) de micro-ondes par la deuxième sortie (33) du diviseur (3) de puissance, **dont la caractéristique essentielle est** qu'entre la première sortie (32) du diviseur (3) de puissance et l'antenne (4) d'émission du canal d'essai et/ou entre la deuxième sortie (33) du diviseur (3) de puissance et l'antenne (6) d'émission du canal de référence il est connecté un bloc (5) de commande de phase et/ou d'amplitude où l'antenne (4) d'émission du canal d'essai, l'antenne (6) d'émission du canal de référence et l'ensemble (8) d'antennes de réception sont placés dans l'espace de telle sorte que la caractéristique d'émission de l'antenne (4) d'émission du canal d'essai et la caractéristique d'émission de l'antenne (6) d'émission du canal de référence soient orientées en direction vers l'ensemble (8) d'antennes de réception et en même temps la caractéristique d'émission de l'ensemble (8) d'antenne de réception est orientée en direction vers l'antenne (4) d'émission du canal d'essai et vers l'antenne (6) d'émission du canal de référence ou la caractéristique d'émission de l'antenne (4) d'émission du canal d'essai est orientée en direction vers l'objet (7) étudié et la caractéristique d'émission de l'antenne (6) d'émission du canal de référence est orientée en direction vers l'ensemble (8) d'antennes de réception et la caractéristique d'émission de l'ensemble (8) d'antennes de réception est orientée en direction vers l'objet (7) étudié et vers l'antenne (6) d'émission du canal de référence.

2. Système selon la revendication 1 **dont la caractéristique essentielle est que** le bloc (5) de commande de phase et/ou d'amplitude est interconnecté avec l'ordinateur (2).

3. Système selon les revendications 1 ou 2 **dont la caractéristique essentielle est que** le générateur (1) de micro-ondes est accordable.

4. Système pour la mesure vectorielle de l'intensité du champ électromagnétique, où ce système contient une antenne (4) d'émission d'un canal d'essai, le premier générateur (1) de micro-ondes, un ensemble (8) d'antennes des antennes de réception ayant les sorties des antennes particulières, des capteurs de puissance (Di), un bloc (9) de commutateurs, un convertisseur A/N (10), un ordinateur (2), et une antenne (6) d'émission du canal de référence, où les sorties des antennes particulières de l'ensemble (8) d'antennes des antennes de réception sont par les capteur de puissance ($D_i$) connectées directement ou à l'aide du bloc (9) de commutateurs avec le convertisseur A/N (10) interconnecté avec l'ordinateur (2) gérant le bloc (9) de commutateurs, le canal d'essai est fait par l'antenne (4) d'émission du canal d'essai connectée à la sortie de micro-ondes du premier générateur (1) de micro-ondes et le canal de référence est fait par l'antenne (6) d'émission du canal de référence, **dont la caractéristique essentielle est qu'**en autre ce système contient le deuxième générateur (11) de micro-ondes, l'antenne (6) d'émission du canal de référence est connectée à la sortie de micro-ondes du deuxième générateur (11) de micro-ondes, dont le signal est cohérent avec le signal du premier générateur (1) de micro-ondes, où le premier générateur (1) de micro-ondes et le deuxième générateur (11) de micro-ondes sont interconnectés avec le bloc (12) de commande de décalage mutuel de phase et d'amplitude de leurs signaux cohérents avec l'option de définir le décalage mutuel de phase et l'amplitude de ces signaux cohérents par l'ordinateur (2), où l'antenne (4) d'émission du canal d'essai, l'antenne (6) d'émission du canal de référence et l'ensemble (8) d'antennes de réception sont placés dans l'espace de telle sorte que la caractéristique d'émission de l'antenne (4) d'émission du canal d'essai et la caractéristique d'émission de l'antenne (6) d'émission du canal de référence soient orientées en direction vers l'ensemble (8) d'antennes de réception et en même temps la caractéristique d'émission de l'ensemble (8) d'antenne de réception est orientée en direction vers l'antenne (4) d'émission du canal d'essai et vers l'antenne (6) d'émission du canal de référence ou la caractéristique d'émission de l'antenne (4) d'émission du canal d'essai est orientée en direction vers l'objet (7) étudié et la caractéristique d'émission de l'antenne (6) d'émission du canal de référence est orientée en direction vers l'ensemble (8) d'antennes de réception et la caractéristique d'émission de l'ensemble (8) d'antennes de réception est orientée en direction vers l'objet (7) étudié et vers l'antenne (6) d'émission du canal de référence.

5. Système selon la revendication 4 **dont la caractéristique essentielle est que** le premier générateur (1) de micro-ondes et le deuxième générateur (11) de micro-ondes sont accordables.

Examined object

**7**

Test. channel

**4**

**32**
**33**

**31**
**3**

**1**

**5**
**6**

Ref. channel

**8**
$D_i$
**9**

**2**

A/D **10**

Fig. 1

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. M. SHEEN ; D. L. MCMAKIN ; T. E. HALL.** Three-Dimensional Millimeter-Wave Imaging for Concealed Weapon Detection. *IEEE Trans. Microwave Theory Tech.,* September 2001, vol. 49, 1581-1592
- **F. FRIEDERICH ; W. SPIEGEL ; M. BAUER ; F. MENG ; M. D. THOMPSON ; S. BOPPEL ; A. LISAUSKAS ; B. HILS ; G. SPICKERMANN ; P. H. BOLÍVAR, H. G. ROSKOS.** THz Active Imaging Systems with Real-Time Capabilities. *IEEE Trans. Terahertz Science and Technology,* September 2011, vol. 1 (1), 183-200
- **ZELA J. ; HOFFMANN K. ; HUDEC P.** Errors in Measurement of Microwave Interferograms Using Antenna Matrix. *Radioengineering,* September 2008, vol. 17 (2), 25-32
- **ENGEN, G. F.** The Six-Port Reflectometer: An Alternative Network Analyzer. *IEEE Trans. Microwave Theory Tech.,* December 1997, vol. 25, 1075-1080
- **OLDFIELD, L. C. ; IDE, J. P. ; GRIFFIN, E. J.** A Multistate reflectometer. *IEEE Trans. IM.,* June 1985, vol. 34 (2), 198-201